# EUROPÄISCHE PATENTSCHRIFT

(11) **EP 3 221 719 B1**
(45) Veröffentlichungstag und Bekanntmachung des Hinweises auf die Patenterteilung: **08.01.2020**
(21) Anmeldenummer: 15798076.4
(22) Anmeldetag: 20.11.2015
(51) Int. Cl.: G01T 1/24, H01L 31/0203

(54) **AUFNAHMEBEHÄLTER FÜR EINEN IN EINEM ULTRAHOCHVAKUUM ODER IN EINER SCHUTZGASATMOSPHÄRE AUS HOCHREINEM GAS ARBEITENDEN DETEKTOR**
CONTAINER FOR A DETECTOR OPERATING IN AN UHV OR HIGH PURITY GAS ATMOSPHERE
RÉCIPIENT POUR UN DÉTECTEUR OPÉRANT DANS UNE ATMOSPHÈRE SOUS ULTRA-VIDE OU GAZ DE HAUTE PURETÉ

(30) Priorität: 21.11.2014 DE 102014223831
(43) Veröffentlichungstag der Anmeldung: 27.09.2017
(73) Patentinhaber: Universität zu Köln, 50923 Köln (DE); Canberra France, 67380 Lingolsheim (FR)
(72) Erfinder: REITER, Peter, 50672 Köln (DE); EBERTH, Jürgen, 51107 Köln (DE); HESS, Herbert, 41069 Mönchengladbach (DE); THIEL, Stefan, 53639 Königswinter (DE); PIRARD, Benoit, F-67980 Hangenbieten (FR); CLAUSS, Jean, 8053 Christchurch (NZ); DELORENZI, Louis, F-68740 Blodelsheim (FR); LAMPERT, Marie Odile, 68000 Colmar (FR)
(74) Vertreter: dompatent von Kreisler Selting Werner - Partnerschaft von Patent- und Rechtsanwälten mbB
(86) Internationale Anmeldenummer: PCT/EP2015/077225
(87) Internationale Veröffentlichungsnummer: WO 2016/079298

(56) Entgegenhaltungen:
- WO-A1-87/05990
- WO-A1-87/05990
- DE-A1- 4 324 709
- DE-A1- 4 324 710
- US-A- 3 609 992
- US-A1- 2004 164 250
- TECHNETICS GROUP EnPro Industries companies: "Helicoflex - spring energized seals", , 20. November 2014 (2014-11-20), XP055248915, Gefunden im Internet: URL:https://web.archive.org/web/2014112008 1207/http://www.techneticsgroup.com/bin/He licoflex.pdf [gefunden am 2016-02-10]
- ROBERT FLITNEY: "Seals and sealing Handbook", REFEREX, Nr. 2.2.3, Mai 2007 (2007-05), - Mai 2007 (2007-05), Seiten 22-27, XP040426302, Elsevier

## Beschreibung

Die vorliegende Erfindung betrifft ein Detektorsystem nach Anspruch 1 mit einem Aufnahmebehälter für einen in einem Ultrahochvakuum (UHV) oder in einer Schutzgasatmosphäre aus hochreinem Gas arbeitenden Detektor, mit einem Aufnahmeteil der zumindest einen Teil des Aufnahmeraumes für den Detektor bildet und einem Deckel zum gasdichten Verschließen des Aufnahmeraumes.

In der Forschung, aber auch in der Industrie, werden Detektoren betrieben, die in einem Ultrahochvakuum oder in höchstreinem Schutzgas bei sehr niedrigen Temperaturen, beispielsweise < -200 °C, arbeiten.

Beispiele für solche Detektoren sind Halbleiterdetektoren für die hochauflösende γ-Spektroskopie, wobei in der Regel Dioden aus Germanium, Silizium, Cadmium-Zink-Tellurid, Gallium-Arsenid oder Cadmium-Tellurid zur Anwendung kommen. Als Detektor werden im Rahmen dieser Patentanmeldung das strahlungssensitive Detektormaterial und somit beispielsweise die genannten Dioden verstanden.

Als besonders vorteilhaft haben sich Detektoren aus hochreinem Germanium herausgestellt, die sich durch eine sehr gute Energieauflösung und eine hohe Nachweiswahrscheinlichkeit für γ-Strahlung auszeichnen. Aufgrund dieser Eigenschaften werden diese Detektormaterialien in der kernphysikalischen Grundlagenforschung, im Strahlenschutz, in der Umweltüberwachung, der zerstörungsfreien Materialanalyse, der industriellen Fertigungskontrolle oder auch in der Weltraumforschung eingesetzt.

Detektoren aus hochreinem Germanium müssen zur Messung auf Temperaturen bis zu -200 °C abgekühlt werden, um das thermische Rauschen der Dioden zu unterdrücken. Es ist bekannt, dazu die Detektoren in einem Vakuumkryostaten einzubauen, der gleichzeitig die empfindliche Oberfläche des Detektors vor Verunreinigungen schützt.

Üblicherweise werden die Bauformen der Kryostate an die jeweilige Messaufgabe angepasst. Wegen der Empfindlichkeit der intrinsischen Oberfläche der Detektoren gegenüber Verunreinigungen können die Detektoren nur von dem Detektorhersteller in die Kryostaten eingebaut werden. Dies bedeutet, dass der Anwender üblicherweise für unterschiedliche Messaufgaben unterschiedliche Kryostate mit Detektoren benötigt.

Ein weiterer Nachteil der klassischen Kryostatentechnik ist die Schwierigkeit, eine Anordnung von vielen dicht gepackten Detektoren zu realisieren, wie es beispielsweise bei der Umweltüberwachung aus Flugzeugen oder in der Weltraumforschung notwendig ist.

Es wurden daher hermetisch gekapselte Detektoren entwickelt, wodurch die Zuverlässigkeit der Detektoren wesentlich verbessert ist und der Aufbau von kompakten Multidetektorsystemen in einem gemeinsamen Kryostaten möglich wird. Derartig eingekapselte Detektoren sind beispielsweise aus DE 43 24 709 und DE 43 24 710 bekannt.

Bei diesen Detektoren ist ein Behälter vorgesehen, der den Detektor eng umschließt. Der Behälter besteht aus einem Aufnahmeteil, der mit einem Deckel verschlossen ist. Der Deckel wird mittels eines Elektronenstrahls oder Laserstrahlung im Vakuum mit dem Aufnahmeteil verschweißt. In dem Deckel sind Durchlässe vorgesehen, durch die Leitungen für die Detektorhochspannung, Signalleitungen oder auch ein Abpumprohr zum Evakuieren der Detektoreinheit mittels Einsätzen geführt sind. Die Einsätze sind in die Durchlässe eingeschweißt. Ferner ist an der Innenseite des Deckels ein Getterelement angeordnet, das ein Vakuum von < 10⁻⁶ mbar im Temperaturbereich zwischen -200 °C bis 200 °C über Jahrzehnte aufrecht erhält. Dieser Temperaturbereich ist nötig, da einerseits für die Messung eine Betriebstemperatur von ca. -190 °C notwendig ist, zum anderen strahlungsinduzierte Kristallschäden in den Detektoren bei einer Temperatur zwischen 80 - 200 °C ausgeheilt werden können.

Die Herstellung der vorbekannten Behälter ist relativ aufwändig, insbesondere die Schweißvorgänge zum Einbringen der Einsätze in den Deckel und das Verschließen des Behälters. Fehler können jedoch erst aufgedeckt werden, wenn der Detektor im Betrieb und auf die Betriebstemperatur von -190 °C herunter gekühlt ist. Sind in dem Produktionsprozess Fehler aufgetreten, kann der Behälter nur durch Abfräsen der Schweißnaht wieder geöffnet werden. Bei geeigneter Konstruktion der Schweißlippe kann der Behälter in der Regel ein weiteres Mal zugeschweißt werden. Bei einer weiteren Öffnung des Behälters muss dieser komplett erneuert werden. Dies ist insbesondere problematisch, da im Laufe eines mehrjährigen Messbetriebs sich die Eigenschaften der Germanium Diode verschlechtern können, so dass eine Reparatur des in dem Behälter aufgenommenen Detektors notwendig ist. Dies führt somit üblicherweise zu einer oder mehreren Öffnungen des Behälters während der Lebensdauer.

Die Herstellung eines einsatzbereiten Detektors mit Behälter sowie die Reparatur eines solchen sind somit mit hohen Kosten verbunden.

Es existieren ferner ortsempfindliche Detektoren, bei denen die Kontakte der Germanium-Dioden segmentiert sind. Der Herstellungsprozess derartiger segmentierter Detektoren und geeigneter Behälter ist im Vergleich zu Standarddetektoren wesentlich komplexer, so dass die Ausfallrate bei der Produktion deutlich höher ist. Die Funktion eines derartigen Detektors kann jedoch erst nach dem Einbringen in einen Behälter geprüft werden, so dass die Notwendigkeit eines nachträglichen Öffnens eines Behälters bei derartigen Detektoren besonders häufig vorkommt. Dadurch resultieren bei dieser Art von Detektoren durch die bisherige Technologie besonders hohe Produktions- und Reparaturkosten.

Ferner entsteht bei dem Schweißvorgang des Behälters ein hoher Wärmeeintrag in dem Behälter und es können Gase und Dämpfe entstehen, die sich auf dem Detektor niederschlagen können. Zudem führt der Wärmeeintrag zur Reduzierung der Festigkeit des Behälters und des Deckels im Bereich der Wärmeeinflusszone. Daher sind besondere Schutzmaßnahmen des Detektors notwendig, wie beispielsweise in DE 43 24 710 beschrieben ist. Dadurch wird die Montage des Detektors in den Aufnahmebehälter stark verkompliziert.

US 2004/0164250 A1 und US 3 609 992 A offenbaren jeweils einen Aufnahmebehälter nach dem Oberbegriff von Anspruch 1.

Es ist daher die Aufgabe der vorliegenden Erfindung, einen Aufnahmebehälter für einen in einem Ultrahochvakuum oder in einer Schutzgasatmosphäre aus hochreinem Gas arbeitenden Detektor zu schaffen, bei dem die Montage in dem Aufnahmebehälter vereinfacht ist und darüber hinaus eine Wartung oder Reparatur des Detektors vereinfacht und ohne Zerstörung des Behälters möglich ist.

Die Erfindung ist definiert durch die Merkmale des Anspruchs 1.

Bei dem erfindungsgemäßen Aufnahmebehälter für einen in einem Ultrahochvakuum oder in einer Schutzgasatmosphäre aus einem hochreinen Gas arbeitenden aus strahlungssensitivem Material bestehenden Detektor, mit einem Aufnahmeteil der zumindest einen Teil des Aufnahmeraumes für den Detektor bildet und einem Deckel zum gasdichten Verschließen des Aufnahmeraums ist vorgesehen, dass an dem Aufnahmeteil eine erste Dichtfläche und an dem Deckel eine zweite an die erste Dichtfläche angepasste Dichtfläche angeordnet ist und dass zwischen den Dichtflächen eine Dichtung angeordnet ist, wobei eine Sicherungseinrichtung den Deckel zur Bereitstellung eines definierten Anpressdrucks der Dichtung gegen das Aufnahmeteil drückt. Als Detektor werden im Rahmen der Erfindung strahlungssensitive Detektormaterialien verstanden, die beispielsweise als Block mit zumindest teilweise hexagonalem Querschnitt vorliegen können. Durch den Deckel wird die zwischen der ersten und der zweiten Dichtfläche angeordnete Dichtung elastisch verformt wodurch diese mit dem definierten Anpressdruck gegen die erste und die zweiten Dichtfläche drückt. Das Aufnahmeteil bildet somit eine Aufnahmeöffnung des Aufnahmeraums, die mittels des Deckels verschließbar ist.

Unter gasdichtem Verschließen wird im Rahmen der Erfindung ein Abdichten des Aufnahmeraums im Hinblick auf Luft oder ein in dem Aufnahmeraum enthaltenen Gas verstanden. Dies geschieht hauptsächlich, um die sehr empfindliche Detektoroberfläche von Verunreinigungen zu schützen. Die Dichtigkeit soll dabei je nach Anforderung in eine Richtung oder beide Richtungen vorliegen. So soll gewährleistet sein, dass bei einer Verwendung einer Schutzgasatmosphäre aus einem hochreinen Gas dieses nicht aus dem Aufnahmebehälter entweicht und/oder keine Luft oder anderes Gas von außen in den Aufnahmebehälter eindringt. Bei der Verwendung des Aufnahmebehälters mit einem Ultrahochvakuum soll gewährleistet sein, dass kein Gas oder keine Luft von außen in den Aufnahmebehälter eindringt. Bei einer häufigen Anwendungsform wird der Aufnahmebehälter in einem Vakuum betrieben, um die Kühlung mit flüssigem Stickstoff zu gewährleisten. Bei einer derartigen Anwendungsform soll durch das gasdichte Verschließen des Aufnahmeraums gewährleistet werden, dass ein vorgegebener Gasdruck in dem Aufnahmeraum erhalten bleibt. Der erfindungsgemäße Aufnahmebehälter ist durch das Vorsehen von Deckel, Sicherungseinrichtung und Dichtung zerstörungsfrei öffenbar und somit wiederverwendbar, d.h. die aufwendig produzierten Aufnahmebehälter können mit neuen Detektoren bestückt werden oder eine Reparatur eines Detektors ist möglich.

Die erfindungsgemäßen Aufnahmebehälter sind insbesondere in einem Temperaturbereich von -200°C bis +200°C einsetzbar. Die normalerweise bei einer Temperatur von bis -200°C arbeitenden Detektoren können im Einsatz Strahlungsschäden erleiden. Diese sind bei einer Regenerierung der Detektoren bei Temperaturen im Bereich bis zu +200°C ausheilbar. Somit werden die Aufnahmebehälter und die darin enthaltenen Detektoren einem Temperaturbereich von -200°C bis +200°C ausgesetzt.

Die Sicherungseinrichtung kann insbesondere lösbar ausgestaltet sein. Insbesondere kann die Sicherungseinrichtung als ein- oder mehrteiliger, lösbarer Sicherungsring ausgebildet sein, der auf den Deckel drückt.

Dadurch wird erreicht, dass der Aufnahmebehälter auf einfache Art und Weise wieder geöffnet werden kann, wodurch eine Reparatur oder ein Austausch des in dem Aufnahmebehälter aufgenommenen Detektors vereinfacht möglich ist, da der Zugang zu dem Detektor auf einfache Art und Weise möglich ist. Ferner kann der Aufnahmebehälter häufiger als ein verschweißter Behälter wiederverwendet werden, da der Aufnahmebehälter durch ein Abnehmen des Deckels nach dem Lösen der Sicherungseinrichtung geöffnet werden kann. Dies kann auf einfache Art und Weise zerstörungsfrei erfolgen.

Der Aufnahmebehälter kapselt den Detektor ein und umschließt ihn gasdicht. Nach einer entsprechenden Evakuierung des Aufnahmeraums und/oder bei dem Einlassen des hochreinen Gases kann der Detektor dann auf die optimale Betriebstemperatur gebracht werden und ist einsatzbereit.

Durch das Vorsehen einer Sicherungseinrichtung, die den Deckel gegen das Aufnahmeteil drückt, kann ein definierter Anpressdruck der Dichtung erzeugt werden, wodurch in vorteilhafter Weise ein gasdichtes Verschließen des Behälters erfolgen kann. Für einen Detektor, der in einer Schutzgasatmosphäre aus hochreinem Gas arbeitet, stellt die Dichtung die gewünschte Dichtigkeit im Hinblick auf dieses Gas bereit.

Durch die Wahl einer geeigneten Dichtung und der Bereitstellung des für diese Dichtung geeigneten Anpressdrucks mittels der Sicherungseinrichtung kann in vorteilhafter Weise eine maximale Leckrate in dem notwendigen Temperaturbereich bereitgestellt werden. Ferner kann erreicht werden, dass durch den definierten Anpressdruck die erste und die zweite Dichtfläche nicht beschädigt werden, so dass eine Wiederverwendbarkeit des Aufnahmebehälters ohne Bearbeitung der ersten und zweiten Dichtfläche möglich ist.

Erfindungsgemäß ist vorgesehen, dass die Dichtung eine elastische Metalldichtung ist. Durch die Elastizität wird gewährleistet, dass in einem größeren Temperaturbereich der Anpressdruck der Dichtung nahezu unverändert aufrecht erhalten wird. Bei Germanium-Detektoren ist dieser Temperaturbereich beispielsweise zwischen -200 °C und 200 °C. Die Elastizität der Dichtung gleicht in diesem Temperaturbereich auftretende Wärmedehnungen aus, so dass die Dichtigkeit des Aufnahmebehälters gewährleistet ist.

Ferner ist erfindungsgemäß vorgesehen, dass die Dichtung aus einer von einem elastischen Rohr, vorzugsweise einem Metallrohr, umgebenden Spiralfeder besteht. Das Rohr kann beispielsweise geschlitzt sein.

Eine derartige Dichtung hat sich als besonders vorteilhaft herausgestellt. Insbesondere kann mit einer derartigen Dichtung in vorteilhafter Weise die gewünschte Leckrate, die beispielsweise < 10⁻¹⁰ mbar x l/s ist, erreicht werden.

Beschädigungen der Dichtfläche werden beim Anlegen des Anpressdrucks vermieden, da das Material des Rohres plastisch verformbar ist. Dadurch kann erreicht werden, dass der erfindungsgemäße Aufnahmebehälter wiederverwendbar ist, da die erste und die zweite Dichtfläche auch nach Gebrauch des Aufnahmebehälters die notwendige Beschaffenheit für eine weitere Verwendung aufweisen.

Das Aufnahmeteil kann beispielsweise eine Becherform besitzen. Insbesondere kann vorgesehen sein, dass die Form des Aufnahmeteils an die Außenform des Detektors angepasst ist, so dass das Aufnahmeteil eng an dem Detektor anliegt.

Das Aufnahmeteil kann dünnwandige Wandungen aufweisen. Beispielsweise kann vorgesehen sein, dass die Wandstärke der Wandungen des Aufnahmeteils zwischen 0,7% und 1,5% des maximalen Durchmessers der Aufnahmeöffnung beträgt. Unter maximalem Durchmesser wird die maximale Erstreckung der Aufnahmeöffnung verstanden. Bei einer runden Aufnahmeöffnung ist der maximale Durchmesser beispielsweise der doppelte Radius der Aufnahmeöffnung, bei einer elliptischen Aufnahmeöffnung ist der maximale Durchmesser die doppelte Länge der langen Halbachse. Beispielsweise kann der maximale Durchmesser der Aufnahmeöffnung zwischen 60 mm und 80 mm betragen. Die Wandstärke kann beispielsweise zwischen 0,7 mm und 0,8 mm betragen. Eine derartige Wandstärke hat sich als besonders vorteilhaft herausgestellt um eine ausreichende Stabilität des Aufnahmeteils zur Aufnahme des Detektors zu erhalten und gleichzeitig das durch die Wandungen für die zu detektierende Strahlung gebildete Hindernis zu minimieren.

Das Aufnahmeteil und/oder der Deckel können aus einer Aluminiumlegierung, beispielsweise ALMg4,5Mn, oder aus Titan oder Magnesium oder einer Titan- oder Magnesiumlegierung bestehen.

Zwischen dem Detektor und den Wandungen des Aufnahmeteils kann ein Spalt vorgesehen sein. Dadurch wird eine elektrische Isolierung von Detektor und den Wandungen des Aufnahmeteils erreicht. Bei Aufnahmebehältern aus elektrisch leitenden Material ist eine elektrische Isolierung notwendig, um eine elektrische Kontaktierung des Detektors zur Signalaufnahme zu ermöglichen. Der Spalt kann eine Breite zwischen 0,3 mm und 0,5 mm aufweisen. Eine derartige Spaltbreite hat sich als besonders vorteilhaft herausgestellt um eine elektrische Isolierung zu erhalten und gleichzeitig zu verhindern, dass durch den Spalt für die zu detektierende Strahlung ein Hindernis gebildet wird. Ferner wird eine sehr kompakte Bauform ermöglicht.

Zwischen den Wandungen und dem Detektor können Abstandshalter angeordnet sein, die den Detektor in einem Abstand zu den Wandungen zur Bildung des Spaltes halten. Die Abstandshalter können beispielsweise aus Keramik oder einem hitzebeständigen Kunststoff, beispielsweise Polyimide, z.B. Kapton erhältlich von DuPont, bestehen.

Vorzugsweise ist dabei vorgesehen, dass das in Kontakt mit der ersten und der zweiten Dichtfläche stehende Material des elastischen Rohres eine geringere Härte aufweist als das die erste und die zweite Dichtfläche bildende Material. Dadurch wird erreicht, dass an den Dichtflächen vorliegende Oberflächenrauheit ausgeglichen werden können, indem das Material des Rohres sich leicht zumindest teilweise plastisch verformt und in Vertiefungen der Oberfläche der Dichtflächen eingedrückt wird. Die erste und zweite Dichtfläche können beispielsweise einen arithmetischen Mittenrauwert Ra zwischen 0,2 µm und 0,8 µm aufweisen.

Das in Kontakt mit der ersten und der zweiten Dichtfläche stehende Material des elastischen Rohres (Außenmaterial) kann beispielsweise als separate Schicht ausgebildet sein. Beispielsweise kann das in Kontakt mit der ersten und der zweiten Dichtfläche stehende Material des elastischen Rohres aus Reinaluminium, beispielsweise AL99,5, bestehen. Bei einer ersten und zweiten Dichtflächen aus einer Aluminiumlegierung, wie beispielsweise ALMg4,5Mn, wird hierdurch erreicht, dass das Außenmaterial des elastischen Rohres sich verformt, die Dichtflächen hingegen nicht.

Die Spiralfeder kann aus einem Federstahl, beispielsweise einem hochlegiertem Stahl, beispielsweise vom Typ XC80, bestehen. Auf der ersten und zweiten Dichtfläche zugewandten Seite kann das Rohr jeweils einen Vorsprung aufweisen, mit dem das Rohr an ersten und zweiten Dichtfläche anliegt. Dadurch wird eine zur plastischen Verformung des Materials erforderliche Kraft reduziert, da diese auf eine kleinere Fläche wirkt.

Vorzugsweise ist vorgesehen, dass an dem Aufnahmeteil ein Anschlag für den Deckel gebildet ist, wobei bei Anlage des Deckels an dem Anschlag zwischen der ersten und der zweiten Dichtfläche ein vorgegebener Abstand gebildet ist. Auf diese Weise ist sichergestellt, dass die zwischen der ersten und der zweiten Dichtfläche angeordnete Dichtung nur bis zu einem durch den Abstand vorgegebenen Maße verformt wird, so dass die Verformung der Dichtung limitiert ist. Aufgrund dieser elastischen Verformung der Dichtung drückt diese mit dem definierten Anpressdruck gegen die erste und die zweiten Dichtfläche.

In einem bevorzugten Ausführungsbeispiel der Erfindung ist vorgesehen, dass der Aufnahmeraum einen ersten umlaufenden Kragen aufweist, gegen den die Sicherungseinrichtung anliegt. Ferner kann vorgesehen sein, dass der Deckel einen zweiten umlaufenden Kragen aufweist, gegen den die Sicherungseinrichtung anliegt. Dadurch kann die Sicherungseinrichtung in vorteilhafter Weise das Aufnahmeteil und den Deckel aneinander befestigen.

Vorzugsweise ist vorgesehen, dass die erste Dichtfläche an dem ersten Kragen und/oder dass die zweite Dichtfläche an dem zweiten Kragen gebildet ist. Indem die Kragen von dem Aufnahmeteil bzw. dem Deckel abstehen, können diese in vorteilhafter Weise bei der Herstellung des Aufnahmeteils bzw. des Deckels bearbeitet werden, so dass die Dichtflächen in guter Qualität auf einfache Art und Weise hergestellt werden können.

Wenn die Sicherungseinrichtung an dem ersten und zweiten Kragen anliegt, wird der zum Verschließen des Aufnahmebehälters notwendige Druck unmittelbar auf die Kragen ausgeübt, so dass die Anordnung der Dichtflächen an dem ersten und zweiten Kragen den Vorteil hat, dass der Druck auf Deckel und Aufnahmeteil in unmittelbarer Nähe zu der ersten und zweiten Dichtfläche ausgeübt wird und somit ein besonders genauer Anpressdruck der Dichtung bereitgestellt werden kann, ohne dass Verformungen an Deckel oder Aufnahmeteil, die beispielsweise den Abstand zwischen der ersten und zweiten Dichtfläche in ungewollter Weise verändern, zu Ungenauigkeiten führen.

Vorzugsweise ist vorgesehen, dass die Sicherungseinrichtung als zweiteiliger Sicherungsring ausgebildet ist, der den ersten und den zweiten Kragen umgreift. Dadurch kann der erste und der zweite Kragen in vorteilhafter Weise gegeneinander gedrückt werden. Ferner sind an Deckel und Aufnahmeteil keine weiteren Einrichtungen, wie beispielsweise Schraublöcher o.ä., an Deckel oder Aufnahmeteil notwendig. Dadurch können der Deckel und das Aufnahmeteil in vorteilhafter Weise gefertigt werden, wobei ferner bei der Befestigung des Deckels an dem Aufnahmeteil Verformungen an Deckel oder Aufnahmeteil vermieden werden.

Beispielsweise kann vorgesehen sein, dass der Deckel und das Aufnahmeteil rund sind, wohingegen der zweiteilige Sicherungsring mehreckig, beispielsweise sechseckig, mit an den Deckel und das Aufnahmeteil angepasster Form ausgebildet ist. In den im Eckbereich des Sicherungsrings gebildeten Materialverstärkungen können Schrauben vorgesehen sein, die den zweiteiligen Sicherungsring zusammenschrauben und den Deckel an das Aufnahmeteil drücken.

Ferner kann vorgesehen sein, dass der Deckel einen vorspringenden Bereich aufweist, der teilweise in das Aufnahmeteil einführbar ist. Dadurch kann eine Zentrierung des Deckels gewährleistet werden.

Durch das Vorsehen des zweiteiligen Sicherungsrings, der den ersten und zweiten Kragen umgreift, wird ferner gewährleistet, dass die zwischen den an dem ersten und dem zweiten Kragen gebildeten Dichtungsflächen liegende Dichtung durch Einflüsse von außen geschützt ist, da der Sicherungsring einen Zugriff von außen auf die Dichtung verhindert. Dabei kann vorgesehen sein, dass sich ein Teil des zweiteiligen Sicherungsrings über den Bereich, in dem die Dichtung angeordnet ist, erstreckt und diesen Bereich somit schützt.

In einem zweiten, alternativ zu dem Ausführungsbeispiel mit dem umlaufenden Kragen vorgesehenen Ausführungsbeispiel der Erfindung ist vorgesehen, dass das Aufnahmeteil eine von einer Wandung des Aufnahmeteils umgebende Aufnahmeöffnung aufweist, wobei die Aufnahmeöffnung in den Aufnahmeraum übergeht, wobei der Deckel in die Aufnahmeöffnung einsetzbar ist und wobei die erste Dichtfläche an einem in die Aufnahmeöffnung ragenden Vorsprung der Wandung gebildet ist. Während bei dem ersten beschriebenen Ausführungsbeispiel der Deckel nur teilweise in dem oberen Randbereich in den Aufnahmeraum eingreift und weitestgehend auf das Aufnahmeteil aufgesetzt ist, ist bei diesem Ausführungsbeispiel vorgesehen, dass der Deckel in das Aufnahmeteil eingesetzt wird. Dabei ist vorgesehen, dass die Wandung ein nach innen gerichtetes Gewinde aufweist und die Sicherungseinrichtung ein nach außen gerichtetes Gewinde aufweist, das mit dem nach innen gerichteten Gewinde zusammen wirkt. Mit anderen Worten: Die Sicherungseinrichtung kann in die Aufnahmeöffnung eingeschraubt werden. Dabei kann die Sicherungseinrichtung beispielsweise ein einteiliger Sicherungsring sein.

Dadurch ist auf einfache Art und Weise möglich, die Sicherungseinrichtung gegen den Deckel und somit die Dichtungsflächen gegen die Dichtung zu drücken.

In der Sicherungseinrichtung können Spannschrauben vorgesehen sein, die gegen den Deckel drücken und die Sicherungseinrichtung in dem nach innen gerichteten Gewinde verspannen. Dadurch kann einerseits in vorteilhafter Weise ein definierter Anpressdruck der Dichtung erreicht werden und andererseits wird verhindert, dass sich die Sicherungseinrichtung löst und somit der Anpressdruck verringert wird.

Bei den beiden alternativen Ausführungsbeispielen der Erfindung kann vorgesehen sein, dass der Deckel mindestens einen Durchlass zum Einsetzen eines Einsatzes mit einem Getterelement, eines Einsatzes mit einem Rohr zum Evakuieren des Aufnahmeraums oder eines Einsatzes für eine elektrische Leitung oder einer elektrischen Steckverbindung aufweist. Durch das Getterelement kann ein in dem Aufnahmeraum erzeugtes Vakuum in vorteilhafter Weise über mehrere Jahre aufrecht erhalten werden. Das Vorsehen eines Einsatzes mit einem Rohr zum Evakuieren des Aufnahmeraumes ermöglicht auf einfache Art und Weise ein Vakuum in dem Aufnahmeraum. Selbstverständlich ist es auch möglich, über das Rohr eine gewünschte Schutzgasatmosphäre bereitzustellen.

Mittels des Einsatzes für eine elektrische Leitung oder Steckverbindung lässt sich die für den Betrieb notwendige Detektorhochspannung an den Detektor anlegen. Auch ist es möglich, über weitere elektrische Steckverbindungen Signalleitungen nach außen zu führen.

Dabei kann vorgesehen sein, dass der Durchlass eine an einem Vorsprung gebildete dritte Dichtfläche und der Einsatz eine vierte Dichtfläche aufweisen, wobei zwischen der dritten und der vierten Dichtfläche eine weitere Dichtung angeordnet ist. Die Einsätze lassen sich somit lösbar in dem Deckel befestigen, so dass bei einer Reparatur des erfindungsgemäßen Aufnahmebehälters beispielsweise das Getterelement ausgetauscht werden kann. Auch ist es möglich, einen Einsatz mit einem neuen Rohr zum Evakuieren des Aufnahmeraumes vorzusehen.

Die Dichtung kann beispielsweise eine elastische Metalldichtung sein und identisch oder ähnlich zu der Dichtung zwischen dem Deckel und dem Aufnahmeteil ausgebildet sein. Insbesondere kann die weitere Dichtung aus einer von einem elastischen Rohr umgebenden Spiralfeder bestehen. Ferner kann vorgesehen sein, dass das in Kontakt mit der dritten und vierten Dichtfläche stehende Material des elastischen Rohres eine geringere Härte aufweist als das die dritte und vierte Dichtfläche bildende Material. Dadurch kann erreicht werden, dass der erfindungsgemäße Aufnahmebehälter wiederverwendbar ist, da die dritte und die vierte Dichtfläche auch nach Gebrauch des Aufnahmebehälters die notwendige Beschaffenheit für einen weitere Verwendung aufweisen.

Vorzugsweise ist vorgesehen, dass an dem Deckel ein weiterer Anschlag für den Einsatz gebildet ist, wobei bei Anlage des Einsatzes an dem weiteren Anschlag zwischen der dritten und der vierten Dichtfläche ein vorgegebener Abstand gebildet ist. Auf diese Weise ist sichergestellt, dass die zwischen der dritten und der vierten Dichtfläche angeordnete weitere Dichtung nur bis zu einem durch den Abstand vorgegebenen Maße verformt wird, so dass die Verformung der weiteren Dichtung limitiert ist. Aufgrund dieser elastischen Verformung der weiteren Dichtung drückt diese mit dem definierten Anpressdruck gegen die dritte und die vierte Dichtfläche.Der Einsatz kann in den Durchlass einschraubbar ausgebildet sein. Dadurch kann auf einfache Art und Weise ein lösbares Einsetzen des Einsatzes in den Durchlass ermöglicht werden. Der Durchlass kann dazu ein nach innen gerichtetes Gewinde aufweisen, wobei der Einsatz ein an dieses Gewinde angepasstes außenliegendes Gewinde aufweist. Durch das Einschrauben des Einsatzes in den Durchlass lässt sich in vorteilhafter Weise ein für die weitere Dichtung notwendiger definierter Anpressdruck bereitstellen.

Alternativ kann vorgesehen sein, dass eine weitere Sicherungseinrichtung in den Durchlass einschraubbar ist und den Einsatz gegen die weitere Dichtung drückt. Dabei kann vorgesehen sein, dass in der weiteren Sicherungseinrichtung Spannschrauben angeordnet sind, die gegen den Einsatz drücken und weitere Sicherungseinrichtungen in dem Durchlass verspannen. Dadurch kann ein definierter Anpressdruck für die weitere Dichtung bereitgestellt werden, wobei gleichzeitig der Einsatz in dem Durchlass durch Verspannen gesichert ist.

Die erfindungsgemäße elastische Metalldichtung mit einem eine Spiralfeder umgebenden Rohr hat den Vorteil, dass beispielsweise der für eine gewünschte Dichtigkeit notwendige Anpressdruck wesentlich geringer sein kann als übliche Standarddichtungen in der Ultrahochvakuumtechnik, oder dass in dem Temperaturbereich die gewünschte Dichtigkeit in vorteilhafter Weise aufrechterhalten werden kann. Dadurch sind sehr kompakte Ausgestaltungen des erfindungsgemäßen Aufnahmebehälters möglich. Ferner ist die Belastung der Dichtflächen durch die Dichtung geringer. Der Aufnahmebehälter und der Deckel lassen sich somit vollständig aus Materialien, insbesondere aus Metallen bzw. Metalllegierungen, mit niedriger Ordnungszahl Z fertigen, was in der γ-Spektroskopie von besonderem Vorteil ist, da die Absorption und die Streuung der Gammastrahlung durch diese Materialien minimiert ist.

Die Rohre der Dichtungen können beispielsweise mit einem gewünschten Material beschichtet sein. Dadurch lassen sich die Dichtungen in vorteilhafter Weise an nahezu alle Flanschmaterialien anpassen. Je nach Anwendung können daher für den Aufnahmebehälter unterschiedliche Materialien verwendet werden, beispielsweise Materialien mit hoher Festigkeit für Raumfahrtprojekte oder Materialien mit geringer Röntgenfluoreszenz bei der γ-Spektroskopie.

Bei dem erfindungsgemäßen Aufnahmebehälter werden ferner Deformationen durch Verschweißungen von Deckel und Aufnahmeteil vermieden.

Dadurch können die Produktion des Aufnahmebehälters sowie die Anordnung des Detektors in dem Behälter vereinfacht werden. Ferner wird das Risiko einer Beschädigung des Detektors durch den Wegfall eines Schweißvorganges reduziert.

Die Erfindung betrifft ferner ein Detektorsystem mit einem erfindungsgemäßen Aufnahmebehälter, in dem ein Detektor aufgenommen ist.

Der erfindungsgemäße Aufnahmebehälter ermöglicht darüber hinaus eine vereinfachte Reparatur des Detektors bzw. eines Detektorsystems aus Aufnahmebehälter mit Detektor, da der Aufnahmebehälter auf einfache Art und Weise nachträglich geöffnet und wieder verschlossen werden kann.

Die Erfindung wird unter Bezugnahme auf die nachfolgenden Figuren im Detail erläutert. Es zeigen:
- Fig. 1: eine schematische Schnittdarstellung eines ersten Ausführungsbeispiels eines erfindungsgemäßen Aufnahmebehälters mit Detektor
- Fig. 2: eine schematische Draufsicht auf den in Fig. 1 dargestellten Aufnahmebehälter,
- Fig. 3: eine schematische Schnittdarstellung eines zweiten Ausführungsbeispiels eines erfindungsgemäßen Aufnahmebehälters mit Detektor und
- Fig. 4: eine schematische Draufsicht des in Fig. 3 dargestellten Aufnahmebehälters.

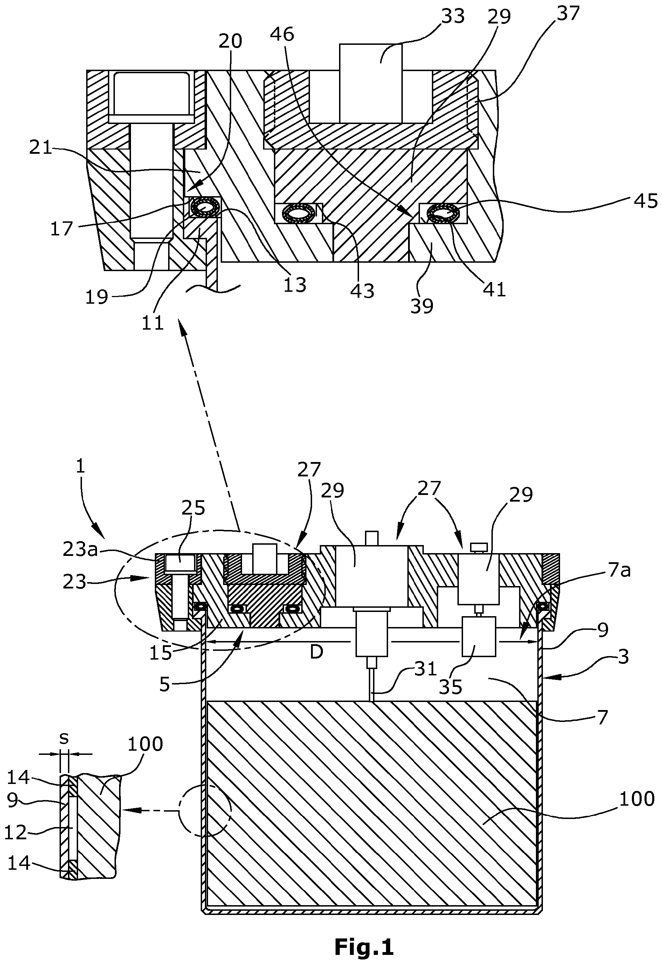

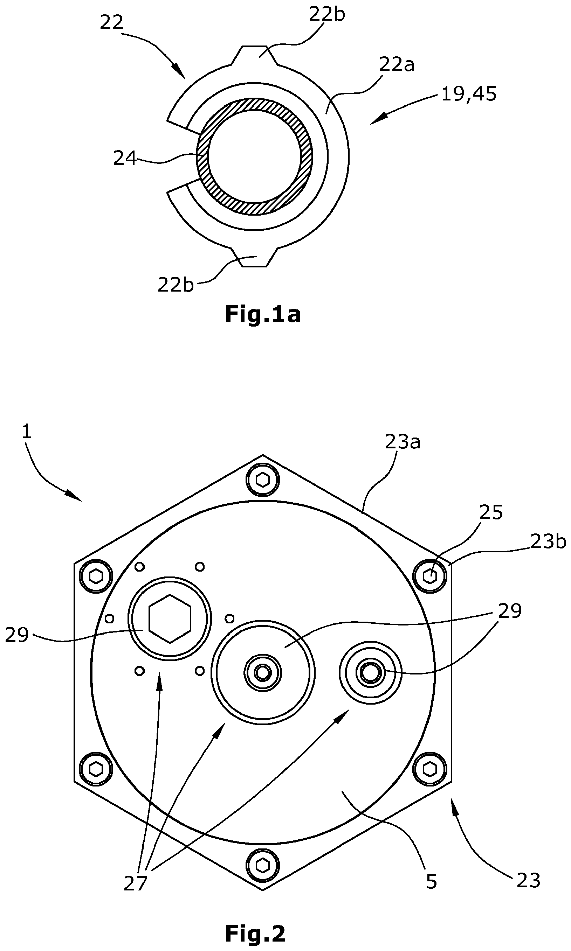

In den Fign. 1 und 2 ist ein erstes Ausführungsbeispiel eines Detektorsystems mit einem erfindungsgemäßen Aufnahmebehälter 1 mit in dem Aufnahmebehälter aufgenommenen aus strahlungssensitiven Detektormaterial bestehenden Detektor 100 dargestellt. Der Detektor 100 arbeitet in einem Ultrahochvakuum oder in einer Schutzgasatmosphäre aus hochreinem Gas. Vakuum oder die Schutzgasatmosphäre werden in dem Aufnahmebehälter erzeugt und über einen längeren Zeitraum aufrecht erhalten.

Der Aufnahmebehälter besteht aus einem Aufnahmeteil 3 und einem Deckel 5, der an dem Aufnahmeteil 3 befestigt ist. Das Aufnahmeteil 3 ist beispielsweise becherförmig ausgestaltet.

Das Aufnahmeteil 3 bildet einen Aufnahmeraum 7 für den Detektor 100. Selbstverständlich ist es auch möglich, dass das Aufnahmeteil 3 nur einen Teil des Aufnahmeraums 7 für den Detektor 100 bildet und ein weiterer Teil des Aufnahmeraums 7 durch den Deckel 5 gebildet wird.

Der Deckel verschließt eine Aufnahmeöffnung 7a des Aufnahmeraums 7 luftdicht bzw. gasdicht, so dass die in dem Aufnahmeraum 7 erzeugte Atmosphäre aufrecht erhalten werden kann.

Das Aufnahmeteil 3 besteht aus einer Wandung 9, die den Aufnahmeraum 7 ringförmig umschließt. Am oberen Rand der Wandung 9 ist ein erster umlaufender Kragen 11 angeordnet. Die Oberfläche des Kragens 11 bildet eine erste Dichtfläche 13. Die Wandstärke s der Wandung 9 beträgt beispielsweise zwischen 0,7 und 1,5% des maximalen Durchmessers D der Aufnahmeöffnung 7a.

Bei der Montage wird der Detektor 100 durch die Aufnahmeöffnung 7a in den Aufnahmeteil 3 eingeführt. Zwischen der Wandung 9 und dem Detektor 100 ist ein Spalt 12 gebildet. Dadurch wird eine elektrische Isolierung von Detektor 100 und den Wandungen 9 des Aufnahmeteils 3 erreicht Der Spalt 12 kann eine Breite zwischen 0,3 mm und 0,5 mm aufweisen. Eine derartige Spaltbreite hat sich als besonders vorteilhaft herausgestellt um eine elektrische Isolierung zu erhalten und eine sehr kompakte Bauweise zu ermöglichen, wobei gleichzeitig verhindert wird, dass durch den Spalt 12 für die zu detektierende Strahlung ein Hindernis gebildet wird.

Zwischen der Wandung 9 und dem Detektor 100 sind Abstandshalter 14 angeordnet, die den Detektor 100 in einem Abstand zu der Wandung 9 zur Bildung des Spaltes 12 halten. Die Abstandshalter können beispielsweise aus Keramik oder einem hitzebeständigen Kunststoff bestehen.

Der Deckel 5 weist einen vorspringenden Teil 15 auf, der sich in die Aufnahmeöffnung 7a des Aufnahmeteils 3 erstreckt und somit von dem oberen Teil der Wandung 9 des Aufnahmeteils 3 zentriert wird. Ferner ist an dem Deckel 5 eine zweite Dichtfläche 17 angeordnet. Die erste und die zweite Dichtfläche 13,17 sind aneinander angepasst und gegenüberliegend angeordnet. Zwischen der ersten und der zweiten Dichtfläche 13,17 ist eine Dichtung 19 angeordnet, die an der ersten und der zweiten Dichtfläche 13,17 anliegt. Der Deckel 5 weist einen zweiten Kragen 21 auf, an dem die zweite Dichtfläche 17 angeordnet ist.

Eine Sicherungseinrichtung 23 drückt den Deckel 5 gegen das Aufnahmeteil 3 und stellt einen definierten Anpressdruck der Dichtung 19 zur Verfügung. Dadurch kann der Aufnahmeraum 7 in vorteilhafter Weise luftdicht bzw. gasdicht verschlossen werden. Hierfür ist vorgesehen, dass an dem Aufnahmeteil 3 ein Anschlag 20 für den Deckel 5 gebildet ist, wobei bei Anlage des Deckels 5 an dem Anschlag 20 zwischen der ersten und der zweiten Dichtfläche 13,17 ein vorgegebener Abstand gebildet ist. Auf diese Weise ist sichergestellt, dass die zwischen der ersten und der zweiten Dichtfläche 13,17 angeordnete Dichtung 19 nur bis zu einem durch den Abstand vorgegebenen Maße verformt wird. Aufgrund dieser elastischen Verformung der Dichtung 19 drückt diese mit dem definierten Anpressdruck gegen die erste und die zweiten Dichtfläche 13,17.

Die Sicherungseinrichtung 23 besteht aus einem zweiteiligen Sicherungsring 23a, der den ersten und den zweiten Kragen 11,21 umgreift und gegeneinander drückt. Dazu ist der zweiteilige Sicherungsring 23a verschraubt. Der zweiteilige Sicherungsring 23a ist, wie am besten aus Fig. 2 hervorgeht, sechseckig ausgebildet, wobei Schrauben 25 in den Eckbereichen 23b des Sicherungsrings 23a angeordnet sind.

In dem Deckel 5 können mehrere Durchlässe 27 vorgesehen sein, in denen Einsätze 29 angeordnet sind. Die Einsätze 29 können eine Hochspannungsleitung 31 für den Detektor 100, ein Rohr 33 zur Evakuierung des Aufnahmeraums 7 oder ein Getterelement 35 aufnehmen. Das Getterelement 35 dient beispielsweise zur Aufrechterhaltung des Vakuums in dem Aufnahmeraum 7 über mehrere Jahre.

Wie in Fig. 1 an Beispiel des Einsatzes 29 mit dem Rohr 33 dargestellt ist, kann der Einsatz 29 über ein Gewinde 37 in den Durchlass 27 eingeschraubt werden. Der Durchlass 27 weist dabei Vorsprünge 39 auf, die eine dritte Dichtfläche 41 bilden. An dem Einsatz 29 ist eine vierte Dichtfläche 43 gebildet, die an die dritte Dichtfläche 41 angepasst ist. Zwischen der dritten und der vierten Dichtfläche 41,43 ist eine weitere Dichtung 45 angeordnet, wobei der Einsatz 29 derart in den Durchlass 27 einschraubbar ist, dass ein definierter Anpressdruck gegen die weitere Dichtung 45 bereitgestellt werden kann. An dem dem Deckel 5 ist durch die Vorsprünge 39 ein weiterer Anschlag 46 für den Einsatz 29 gebildet ist, wobei bei Anlage des Einsatzes 29 an dem weiteren Anschlag 46 zwischen der dritten und der vierten Dichtfläche 41,43 ein vorgegebener Abstand gebildet ist. Auf diese Weise ist sichergestellt, dass die zwischen der dritten und der vierten Dichtfläche 41,43 angeordnete weitere Dichtung 45 nur bis zu einem durch den Abstand vorgegebenen Maße verformt wird. Aufgrund dieser elastischen Verformung der weiteren Dichtung 45 drückt diese mit dem definierten Anpressdruck gegen die dritte und die vierte Dichtfläche 41,43.

Die Dichtung 19 und die weitere Dichtung 45 können als elastische Metalldichtungen ausgebildet sein. Eine entsprechende Dichtung 19, 45 ist in Fig 1a schematisch in einer Schnittdarstellung vergrößert gezeigt. Dabei können die Dichtungen 19,45 aus einer von einem elastischen, geschlitzten Rohr 22 umgebenden Spiralfeder 24 bestehen. Ferner kann vorgesehen sein, dass das elastische Rohr der Dichtungen eine separate Schicht 22a aufweist, die beispielsweise aus Reinaluminium besteht, wobei das in Kontakt mit der ersten und zweiten Dichtfläche 13,17 bzw. der dritten und vierten Dichtfläche 41,43 stehende Material des elastischen Rohres 22 eine geringere Härte aufweist als die entsprechenden Dichtflächen 13,17,41,43. Dadurch wird erreicht, dass Oberflächenrauigkeiten an den Dichtflächen 13,17,41,43 ausgeglichen werden und Beschädigungen der Dichtflächen 13,17,41,43 verhindert werden.

Die separate Schicht kann auf der den Dichtflächen 13,17,41,43 zugewandten Seiten jeweils einen Vorsprung 22b aufweisen, mit dem das elastische Rohr 22 an den Dichtflächen 13,17,41,43 anliegt. Dadurch wird eine zur plastischen Verformung des Materials der separaten Schicht 22a erforderliche Kraft reduziert, da diese auf eine durch die Vorsprünge gebildete, kleinere Fläche wirkt.

Der erfindungsgemäße Aufnahmebehälter 1 kann auf einfache Art und Weise verschlossen werden, indem die Sicherungseinrichtung 23 nach dem Aufsetzen des Deckels 5 auf den Aufnahmeteil 3 den Deckel 5 gegen den Aufnahmeteil 3 drückt. Dazu werden die Schrauben 25 mit einem definierten Drehmoment angezogen. Das Öffnen des erfindungsgemäßen Aufnahmebehälters 1 kann auf einfache Art und Weise durch Lösen der Schrauben 25 erfolgen, wobei ein zerstörungsfreies Öffnen erfolgen kann.

Durch die Verwendung von Einsätzen 29, die in die Durchlässe 27 eingeschraubt sind, kann beispielsweise das Getterelement 35 oder das Rohr 33 auf einfache Art und Weise ausgetauscht werden.

Die Einsätze 29 können auch andere elektrische Leitungen oder elektrische Steckverbindungen, die beispielsweise zur Signalleitung verwendet werden, aufweisen.

In dem dargestellten Ausführungsbeispiel ist das Aufnahmeteil 3 rund ausgebildet. Je nach Form des Detektors 100 kann das Aufnahmeteil 3 auch eine unterschiedliche Form aufweisen. Insbesondere kann das Aufnahmeteil 3 Abflachungen aufweisen, so dass mehrere in den Aufnahmebehälter 1 angeordnete Detektoren dicht aneinander angeordnet werden können, indem die Abflachungen aneinander anliegen. Dadurch kann eine enge Anordnung der Detektoren erreicht werden, so dass diese in vorteilhafter Weise gemeinsam mittels, beispielsweise einer Kryostatentechnik, auf eine niedrige Betriebstemperatur von beispielsweise -200 °C gebracht werden können.

Der Detektor 100 kann beispielsweise Dioden aus Germanium, Silizium, Cadmium-Zink-Tellurid, Gallium-Arsenid oder Cadmium-Tellurid aufweisen. Insbesondere kann der Detektor aus hochreinem Germanium bestehen.

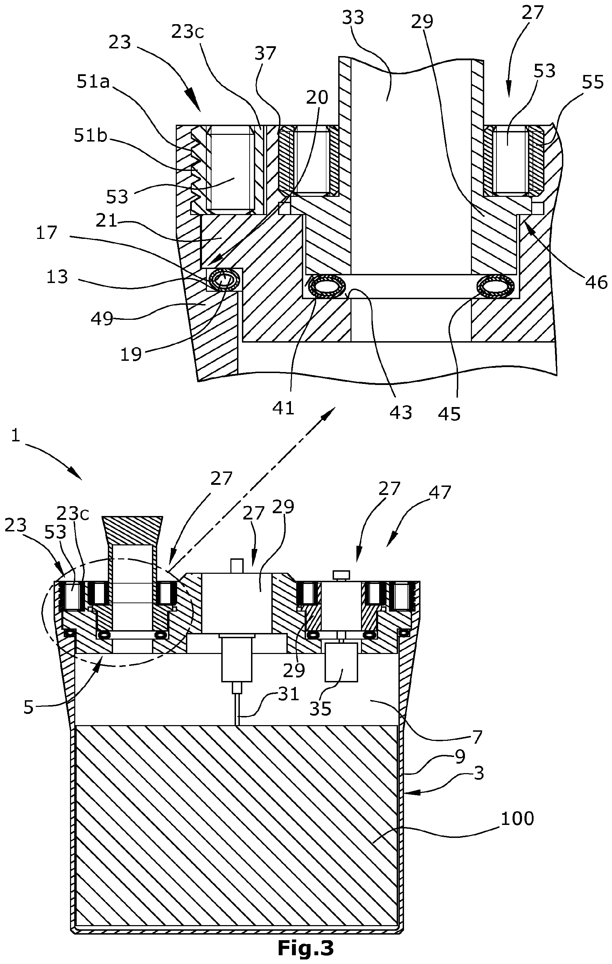

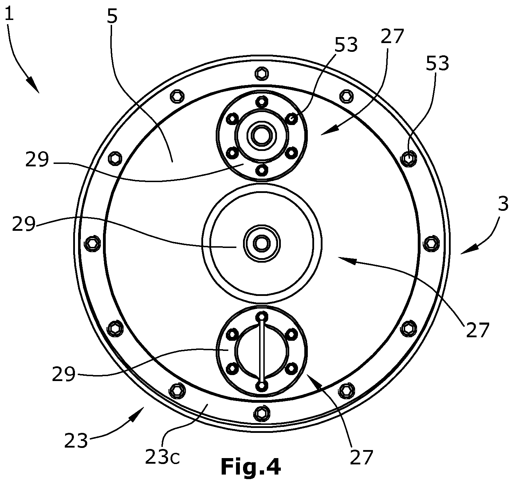

In den Fign. 3 und 4 ist ein zweites Ausführungsbeispiel eines Detektorsystems mit erfindungsgemäßem Aufnahmebehälter 1 mit Detektor 100 dargestellt. Der in den Fign. 3 und 4 dargestellte Aufnahmebehälter 1 weist im Wesentlichen den gleichen Aufbau wie der in den Fign. 1 und 2 dargestellte Aufnahmebehälter 1 auf und besteht ebenfalls aus einem Aufnahmeteil 3 und einem Deckel 5. Unterschiede bestehen in der Befestigung des Deckels 5 an dem Aufnahmeteil 3.

In dem in den Fign. 3 und 4 dargestellten Ausführungsbeispiel weist das Aufnahmeteil 3 eine von der Wandung 9 des Aufnahmeteils 3 umgebende Aufnahmeöffnung 47, die in den Aufnahmeraum 7 übergeht, auf. In die Aufnahmeöffnung 47 ist der Deckel 5 eingesetzt. Die erste Dichtfläche 13 ist an einem in die Aufnahmeöffnung 47 ragenden Vorsprung 49 gebildet. Der Deckel 5 kann in ähnlicher Weise wie der Deckel 5 in dem in den Fign. 1 und 2 dargestellten Ausführungsbeispiel einen zweiten Kragen 21 aufweisen, an dessen Unterseite die zweite Dichtfläche 17 gebildet ist. Die Dichtung 19 ist zwischen der ersten und der zweiten Dichtfläche 13,17 angeordnet und kann in gleicher Weise ausgebildet sein wie bei dem in den Fign. 1 und 2 gezeigten Ausführungsbeispiel.

Die Sicherungseinrichtung 23 ist bei dem in den Fign. 3 und 4 dargestellten Ausführungsbeispiel als einteiliger Sicherungsring 23c ausgebildet. Die Wandung 9 weist dabei im Bereich der Aufnahmeöffnung ein nach innen gerichtetes Gewinde 51a auf. Der einteilige Sicherungsring 23c weist ein an das nach innen gerichtete Gewinde 51a angepasstes, nach außen gerichtetes Gewinde 51b auf, das mit dem nach innen gerichteten Gewinde 51a zusammenwirkt. Mit anderen Worten: Der einteilige Sicherungsring 23c kann in die Aufnahmeöffnung 47 eingeschraubt werden und gegen den Deckel 5 drücken.

In der Sicherungseinrichtung 23 sind Spannschrauben 53 angeordnet, die gegen den Deckel 5 drücken. Mittels der Spannschrauben 53 kann die Sicherungseinrichtung 23 in dem Gewinde 51a,b verspannt werden und ein definierter Druck auf den Deckel 5 ausgeübt werden, wodurch dieser gegen den am Aufnahmeteil gebildeten Anschlag 20gedrückt wird. Dadurch wird die Dichtung 19 elastisch verformt und drückt mit dem definierten Anpressdruck gegen die erste und die zweiten Dichtfläche 13,17.

In dem Deckel 5 sind, genauso wie bei dem in den Fign. 1 und 2 dargestellten Ausführungsbeispiel, Durchlässe 27 zur Aufnahme von Einsätzen 29 angeordnet. Bei dem in den Fign. 3 und 4 dargestellten Ausführungsbeispiel werden die Einsätze 29 in die Durchlässe 27 eingesetzt, so dass die dritte Dichtfläche 41 und die vierte Dichtfläche 43 mit dazwischen liegender Dichtung 45 zusammenwirken. Die Einsätze 29 werden mittels einer weiteren Sicherungseinrichtung 55, die in das Gewinde 37 in dem Durchlass 27 eingeschraubt ist, festgelegt. Ferner weist die weitere Sicherungseinrichtung 55 ebenfalls Spannschrauben 53 auf, die die weitere Sicherungseinrichtung 55 in dem Durchlass 27 verspannen und einen definierten Anpressdruck für die weitere Dichtung 45 bereitstellen, indem die Einsätze 29 gegen weitere Anschläge 46 gedrückt werden.

Die Befestigung der Einsätze 29 in den Durchlässen 27 funktioniert somit im Wesentlichen in vergleichbarer Form wie die Befestigung des Deckels 5 auf den Aufnahmeteil 3.

Bei dem in den Fign. 1 bis 4 dargestellten Ausführungsbeispiel sind nur einzelne Einsätze mit der beschriebenen Befestigungstechnik befestigt dargestellt. Selbstverständlich können sämtliche Einsätze auf diese Art und Weise befestigt werden. Auch ist es möglich, dass nur einzelne, bei einer Reparatur auszutauschende Einsätze auf diese Form befestigt werden und andere Einsätze auf herkömmliche Art und Weise an dem Deckel 5 verschweißt werden.

## Patentansprüche

1. Detektorsystem, mit einem in einem Ultrahochvakuum oder in einer Schutzgasatmosphäre aus hochreinem Gas arbeitenden Detektor (100) und einem Aufnahmebehälter (1) für den Detektor (100), mit einem Aufnahmeteil (3), der zumindest einen Teil des Aufnahmeraums (7) für den Detektor (100) bildet, und einem Deckel (5) zum luftdichten Verschließen des Aufnahmeraums (7), wobei an dem Aufnahmeteil (3) eine erste Dichtfläche (13) und an dem Deckel (5) eine an die erste Dichtfläche (13) angepasste zweite Dichtfläche (17) angeordnet ist, und dass zwischen den Dichtflächen (13,17) eine Dichtung (19) angeordnet ist, wobei das Detektorsystem eine Sicherungseinrichtung (23) umfasst die dazu eingerichtet ist, den Deckel (5) zur Bereitstellung eines definierten Anpressdrucks der Dichtung (19) gegen das Aufnahmeteil (3) zu drücken, **dadurch gekennzeichnet, dass** die Dichtung (19) eine elastische Metalldichtung ist und aus einer von einem elastischen Rohr (22) umgebenen Spiralfeder (24) besteht, wobei das elastische Rohr (22) bei Anliegen des definierten Anpressdrucks zur Vermeidung von Beschädigungen der ersten und der zweiten Dichtfläche (13,17) plastisch verformbar ist, und dass zwischen dem Detektor (100) und Wandungen (9) des Aufnahmeteils (3) ein Spalt (12) zur elektrischen Isolierung von Detektor (100) und den Wandungen (9) gebildet ist, wobei der Spalt eine Breite zwischen 0,3 mm und 0,5 mm aufweist.

2. Detektorsystem nach Anspruch 1, **dadurch gekennzeichnet, dass** das in Kontakt mit der ersten und der zweiten Dichtfläche (13,17) stehende Material des elastischen Rohres (22) eine geringere Härte aufweist als das die erste und die zweite Dichtfläche (13,17) bildende Material.

3. Detektorsystem nach Anspruch 1 oder 2, **dadurch gekennzeichnet, dass** das Aufnahmeteil (3) einen ersten umlaufenden Kragen (11) aufweist, gegen den die Sicherungseinrichtung (23) anliegt.

4. Detektorsystem nach einem der Ansprüche 1 bis 3, **dadurch gekennzeichnet, dass** der Deckel einen zweiten umlaufenden Kragen (21) aufweist, gegen den die Sicherungseinrichtung (23) anliegt.

5. Detektorsystem nach Anspruch 3 oder 4, **dadurch gekennzeichnet, dass** die erste Dichtungsfläche (13) an dem ersten Kragen (11) und/oder dass die zweite Dichtungsfläche (17) an dem zweiten Kragen (21) gebildet ist.

6. Detektorsystem nach Anspruch 4 oder 5, **dadurch gekennzeichnet, dass** die Sicherungseinrichtung (23) als zweiteiliger Sicherungsring (23a) ausgebildet ist, der den ersten und den zweiten Kragen (11,21) umgreift.

7. Detektorsystem nach einem der Ansprüche 1 oder 2 , **dadurch gekennzeichnet, dass** das Aufnahmeteil (3) eine von den Wandungen (9) des Aufnahmeteils (3) umgebende Aufnahmeöffnung (47) aufweist, wobei die Aufnahmeöffnung (47) in den Aufnahmeraum (7) übergeht, wobei der Deckel (5) in die Aufnahmeöffnung (47) einsetzbar ist und wobei die erste Dichtfläche (13) an einem in die Aufnahmeöffnung (47) ragenden Vorsprung (49) den Wandungen (9) gebildet ist.

8. Detektorsystem nach Anspruch 7, **dadurch gekennzeichnet, dass** die Wandungen (9) ein nach innen gerichtetes Gewinde (51a) aufweist und die Sicherungseinrichtung (23) ein nach außen gerichtetes Gewinde (51b) aufweist, das mit dem nach innen gerichteten Gewinde (51a) zusammenwirkt.

9. Detektorsystem nach Anspruch 8, **dadurch gekennzeichnet, dass** in der Sicherungseinrichtung (23) Spannschrauben (53) angeordnet sind, die gegen den Deckel (5) drücken und die Sicherungseinrichtung (23) in dem nach innen gerichteten Gewinde (51a) verspannen.

10. Detektorsystem nach einem der Ansprüche 1 bis 9, **dadurch gekennzeichnet, dass** der Deckel (5) mindestens einen Durchlass (27) eines Einsatzes (29) mit einem Rohr (33) zum Evakuieren des Aufnahmeraumes (7) oder eines Einsatzes (29) für eine elektrische Steckverbindung aufweist.

11. Detektorsystem nach Anspruch 10, **dadurch gekennzeichnet, dass** der Durchlass (27) eine an einem Vorsprung (39) gebildete dritte Dichtfläche (41) und der Einsatz (29) eine vierte Dichtfläche (43) aufweist, wobei zwischen der dritten und der vierten Dichtfläche (41,43) eine weitere Dichtung (45) angeordnet ist.

12. Detektorsystem nach Anspruch 10 oder 11, **dadurch gekennzeichnet, dass** der Einsatz (29) in den Durchlass (27) einschraubbar ist.

13. Detektorsystem nach Anspruch 10 oder 11, **dadurch gekennzeichnet, dass** eine weitere Sicherungseinrichtung (55) in den Durchlass (27) einschraubbar ist und den Einsatz (29) gegen die weitere Dichtung (45) drückt.

14. Detektorsystem nach Anspruch 13, **dadurch gekennzeichnet, dass** in der weiteren Sicherungseinrichtung (55) Spannschrauben (53) angeordnet sind, die gegen den Einsatz (29) drücken und die weitere Sicherungseinrichtung (55) in dem Durchlass (27) verspannen.

## Claims

1. A detector system comprising a detector (100) which operates in an ultrahigh vacuum or in a protective gas atmosphere consisting of high-purity gas, and a receiving container (1) for the detector (100) having a receiving portion (3) which forms at least a portion of the receiving space (7) for the detector (100), and a cover (5) for hermetically sealing the receiving space (7), wherein, at the receiving portion (3), a first sealing surface (13) is arranged and, at the cover (5), a second sealing surface (17) matching the first sealing surface (13) is arranged, and that, between the sealing surfaces (13, 17), a gasket (19) is arranged, wherein the detector systems comprises a securing device (23) which is configured to press the cover (5) against the receiving portion (3) for providing a defined contact pressure of the gasket (19),
**characterized in that**
the gasket (19) is an elastic metal gasket and is composed of a spiral spring (24) surrounded by an elastic tube (22), wherein, when the defined contact pressure is applied, the elastic tube (22) is adapted to be plastically deformed for preventing the first and the second sealing surface (13, 17) from being damaged, and between the detector (100) and walls (9) of the receiving portion (3) a gap (12) for electrical insulation of the detector (100) and the walls (9) is formed, wherein the gap has a width between 0.3 and 0.5 mm.

2. The detector system according to claim 1, **characterized in that** the material of the elastic tube (22) in contact with the first and the second sealing surface (13, 17) has a smaller hardness than the material constituting the first and the second sealing surface (13, 17).

3. The detector system according to claim 1 or 2, **characterized in that** the receiving portion (3) comprises a first circumferential flange (11) upon which the securing device (23) rests.

4. The detector system according to any one of claims 1 to 3, **characterized in that** the cover comprises a second circumferential flange (21) upon which the securing device (23) rests.

5. The detector system according to claim 3 or 4, **characterized in that** the first sealing surface (13) is formed at the first flange (11) and/or that the second sealing surface (17) is formed at the second flange (21).

6. The detector system according to claim 4 or 5, **characterized in that** the securing device (23) is configured as a two-piece locking ring (23a) which encompasses the first and the second flange (11, 21).

7. The detector system according to any one of claims 1 or 2, **characterized in that** the receiving portion (3) comprises a receiving opening (47) surrounded by walls (9) of the receiving portion (3), wherein the receiving opening (47) transitions into the receiving space (7), wherein the cover (5) is adapted to be inserted into the receiving opening (47), and wherein the first sealing surface (13) is formed at a protrusion (49) of the walls (9) extending into the receiving opening (47).

8. The detector according to claim 7, **characterized in that** the walls (9) comprise an internal thread (51a) and the securing device (23) comprises an external thread (51b) which cooperates with the internal thread (51a).

9. The detector system according to claim 8, **characterized in that**, in the securing device (23), clamping screws (53) are arranged which press against the cover (5) and interlock the securing device (23) in the internal thread (51a).

10. The detector system according to any one of claims 1 to 9, **characterized in that** the cover (5) comprises at least one passage (27) of an insert (29) with a tube (33) for evacuating the receiving space (7), or of an insert (29) for an electrical plug connector.

11. The detector system according to claim 10, **characterized in that** the passage (27) comprises a third sealing surface (41) formed at a protrusion (39) and the insert (29) comprises a fourth sealing surface (43), wherein, between the third and the fourth sealing surface (41, 43), a further gasket (45) is arranged.

12. The detector system according to claim 10 or 11, **characterized in that** the insert (29) is adapted to be screwed into the passage (27).

13. The detector system according to claim 10 or 11, **characterized in that** a further securing device (55) is adapted to be screwed into the passage (27) and presses the insert (29) against the further gasket (45).

14. The detector system according to claim 13, **characterized in that** clamping screws (53) are arranged in the further securing device (55) which press against the insert (29) and interlock the further securing device (55) in the passage (27).

## Revendications

1. Système de détecteur, doté d'un détecteur (100) fonctionnant dans un ultravide ou dans une atmosphère protectrice de gaz de haute pureté et d'un récipient d'accueil (1) pour le détecteur (100), doté d'une pièce d'accueil (3), laquelle forme au moins une partie de l'espace d'accueil (7) pour le détecteur (100), et d'un couvercle (5) pour refermer hermétiquement l'espace d'accueil (7), dans lequel une première surface étanche (13) est agencée sur la pièce d'accueil (3) et dans lequel une deuxième surface étanche (17) adaptée à la première surface étanche (13) est agencée sur le couvercle (5), et dans lequel un joint (19) est agencé entre les surfaces étanches (13, 17), dans lequel le système de détecteur comprend un dispositif de sûreté (23), lequel est disposé pour presser le couvercle (5) afin d'obtenir une pression de contact définie du joint (19) contre la pièce d'accueil (3), **caractérisé en ce que** le joint (19) est un joint métallique élastique et est composé d'un ressort hélicoïdal (24) entouré par un tube élastique (22), dans lequel le tube élastique (22) peut être déformé plastiquement lors de l'application de la pression de contact définie afin de prévenir l'endommagement de la première et de la deuxième surface étanche (13, 17), et **en ce qu'**une fente (12) est formée entre le détecteur (100) et les parois (9) de la pièce d'accueil (3) pour isoler électriquement le détecteur (100) et les parois (9), dans lequel la fente possède une largeur entre 0,3 mm et 0,5 mm.

2. Système de détecteur selon la revendication 1, **caractérisé en ce que** le matériau du tube élastique (22) étant en contact avec la première et la deuxième surface étanche (13, 17) possède une dureté inférieure à celle du matériau formant la première et la deuxième surface étanche (13, 17).

3. Système de détecteur selon la revendication 1 ou 2, **caractérisé en ce que** la pièce d'accueil (3) comporte une première collerette périphérique (11), le dispositif de sûreté (23) étant contigu à celle-ci.

4. Système de détecteur selon l'une des revendications 1 à 3, **caractérisé en ce que** le couvercle comporte une deuxième collerette périphérique (21), le dispositif de sûreté (23) étant contigu à celle-ci.

5. Système de détecteur selon la revendication 3 ou 4, **caractérisé en ce que** la première surface d'étanchéité (13) est formée sur la première collerette (11) et/ou **en ce que** la deuxième surface d'étanchéité (17) est formée sur la deuxième collerette (21).

6. Système de détecteur selon la revendication 4 ou 5, **caractérisé en ce que** le dispositif de sûreté (23) est réalisée comme anneau de sûreté (23a) en deux parties, lequel entoure la première et la deuxième collerette (11, 21) .

7. Système de détecteur selon l'une des revendications 1 ou 2, **caractérisé en ce que** la pièce d'accueil (3) comporte une ouverture d'accueil (47) entourée par les parois (9) de la pièce d'accueil (3), dans lequel l'ouverture d'accueil (47) dépasse dans l'espace d'accueil (7), dans lequel le couvercle (5) peut être inséré dans l'ouverture d'accueil (47) et dans lequel la première surface étanche (13) est formée sur une saillie (49) des parois (9) s'avançant dans l'ouverture d'accueil (47) .

8. Système de détecteur selon la revendication 7, **caractérisé en ce que** les parois (9) comportent un filetage orienté vers l'intérieur (51a) et le dispositif de sûreté (23) comporte un filetage orienté vers l'extérieur (51b), lequel coopère avec le filetage orienté vers l'intérieur (51a).

9. Système de détecteur selon la revendication 8, **caractérisé en ce que** des boulons de serrage (53) sont agencés dans le dispositif de sûreté (23), lequel appuient contre le couvercle (5) et serrent le dispositif de sûreté (23) dans le filetage orienté vers l'intérieur (51a).

10. Système de détecteur selon l'une des revendications 1 à 9, **caractérisé en ce que** le couvercle (5) comporte au moins un passage (27) d'un insert (29) doté d'un tube (33) pour l'évacuation de l'espace d'accueil (7) ou d'un insert (29) pour une prise de raccordement électrique.

11. Système de détecteur selon la revendication 8, **caractérisé en ce que** le passage (27) comporte une troisième surface étanche (41) formée sur une saillie (39) et l'insert (29) comporte une quatrième surface étanche (43), dans lequel un joint supplémentaire (45) est agencé entre la troisième et la quatrième surface étanche (41, 43).

12. Système de détecteur selon la revendication 10 ou 11, **caractérisé en ce que** l'insert (29) peut être vissé dans le passage (27).

13. Système de détecteur selon la revendication 10 ou 11, **caractérisé en ce qu'**un dispositif de sûreté supplémentaire (55) peut être vissé dans le passage (27) et l'insert (29) appuie contre le joint supplémentaire (45) .

14. Système de détecteur selon la revendication 13, **caractérisé en ce que** des boulons de serrage (53) sont agencés dans le dispositif de sûreté supplémentaire (55), lesquels appuient contre l'insert (29) et serrent le dispositif de sûreté supplémentaire (55) dans le passage (27) .
